# EUROPEAN PATENT SPECIFICATION

(11) **EP 3 259 229 B1**
(45) Date of publication and mention of the grant of the patent: **28.04.2021**
(21) Application number: 16752742.3
(22) Date of filing: 21.03.2016
(51) Int. Cl.: H01P 5/107, H01P 1/208, H01P 7/06, H01P 11/00, H01Q 13/22, H01Q 21/00, B81C 1/00, B81B 7/00, H01P 3/12

(54) **MEMS CHIP WAVEGUIDE TECHNOLOGY WITH PLANAR RF TRANSMISSION LINE ACCESS**
MEMS-CHIP-WELLENLEITERTECHNOLOGIE MIT PLANAREM HF-ÜBERTRAGUNGSLEITUNGSZUGANG
TECHNOLOGIE DE GUIDE D'ONDES SOUS FORME DE PUCE MEMS AVEC ACCÈS À UNE LIGNE DE TRANSMISSION RF PLANAIRE

(30) Priority: 19.02.2015 SE 1530028
(43) Date of publication of application: 27.12.2017
(73) Proprietor: TRXMEMS AB c/o Tomas Bauer, 197 91 Bro (SE)
(72) Inventor: BAUER, Tomas, 197 91 Bro (SE)
(86) International application number: PCT/SE2016/050233
(87) International publication number: WO 2016/133457

(56) References cited:
- WO-A1-2009/023551
- US-A- 3 193 830
- US-A1- 2003 206 083
- US-A1- 2004 129 958
- US-A1- 2007 229 182
- US-A1- 2010 308 925
- US-A1- 2010 321 132
- US-A1- 2011 102 284
- US-A1- 2014 368 300
- SANGSUB SONG ET AL: "$W$ -Band Bandpass Filter Using Micromachined Air-Cavity Resonator With Current Probes", IEEE MICROWAVE AND WIRELESS COMPONENTS LETTERS, IEEE SERVICE CENTER, NEW YORK, NY, US, vol. 20, no. 4, 1 April 2010 (2010-04-01), pages 205-207, XP011347760, ISSN: 1531-1309, DOI: 10.1109/LMWC.2010.2042552
- ARIF MUHAMMAD SHOAIB ET AL: "All-Silicon Technology for High- $Q$ Evanescent Mode Cavity Tunable Resonators and Filters", JOURNAL OF MICROELECTROMECHANICAL SYSTEMS, IEEE SERVICE CENTER, US, vol. 23, no. 3, 1 June 2014 (2014-06-01), pages 727-739, XP011549798, ISSN: 1057-7157, DOI: 10.1109/JMEMS.2013.2281119 [retrieved on 2014-05-29]
- PELLICCIA LUCA ET AL: "Micromachined filters in multilayer technology for on-board communication systems in Ka-band", IEEE - MTTS INTERNATIONAL MICROWAVE SYMPOSIUM. DIGEST, IEEE, US, 2 June 2013 (2013-06-02), pages 1-3, XP032545938, ISSN: 0149-645X, DOI: 10.1109/MWSYM.2013.6697473 [retrieved on 2013-12-27]
- YUAN LI ET AL: "Design and Characterization of a -Band Micromachined Cavity Filter Including a Novel Integrated Transition From CPW Feeding Lines", IEEE TRANSACTIONS ON MICROWAVE THEORY AND TECHNIQUES, PLENUM, USA, vol. 55, no. 12, 1 December 2007 (2007-12-01), pages 2902-2910, XP011196631, ISSN: 0018-9480, DOI: 10.1109/TMTT.2007.909615
- GENTILE GENNARO ET AL: "Silicon-Filled Rectangular Waveguides and Frequency Scanning Antennas for mm-Wave Integrated Systems", IEEE TRANSACTIONS ON ANTENNAS AND PROPAGATION, IEEE SERVICE CENTER, PISCATAWAY, NJ, US, vol. 61, no. 12, 1 December 2013 (2013-12-01), pages 5893-5901, XP011532785, ISSN: 0018-926X, DOI: 10.1109/TAP.2013.2281518 [retrieved on 2013-11-25]
- YUAN LI ET AL.: 'Design and Characterization of a W-Band Micromachined Cavity Filter Including a Novel Integrated Transition From CPW Feeding Lines' IEEE TRANSACTIONS ON MICROWAVE THEORY AND TECHNIQUES vol. 55, no. 12, December 2007, pages 2902 - 2910, XP011196631 DOI: 10.1109/TMTT.2007.909615
- UEMICHI YUSUKE ET AL.: 'A ultra low-loss silica-based transformer between microstrip line and post-wall waveguide for millimeter-wave antenna-in-package applications' 2014 IEEE MTT-S INTERNATIONAL MICROWAVE SYMPOSIUM (IMS2014) 01 June 2014, TAMPA, USA, pages 1 - 3, XP032615309 DOI: 10.1109/MWSYM.2014.6848279

## Description

The invention discloses a waveguide MEMS chip technology enabling wafer level integrated planar RF transmission line access into the waveguide structure. The waveguide technology with wafer level integration of signal access enables a plurality of smart high frequency functions realized as MEMS microchips with facilitated possible on-chip integration of radio frequency integrated circuits (RFIC) and other functionalities. A wafer level method of making the waveguide structure with signal access is disclosed, where the completed MEMS chip is comprised of at least two wafer substrates that are bonded together using wafer bonding technology

### DESCRIPTION

The present invention relates to a waveguide system as defined in the appended claims and realized as a chip built in MEMS technology incorporating a novel functionality with respect to signal transition into the waveguide and possible on-chip integration of Radio Frequency integrated circuits.

### BACKGROUND OF THE INVENTION

Mainstream waveguide technology requires costly high precision machining of metal parts that very often fall short of achieving required RF specification directly in the machining process and hence require additional costly tuning of the waveguide parts to achieve the desired performance.

Wireless telecommunication is continuously looking to expand into higher frequency bands for wireless communication, and as high frequency means shorter wavelength, this also implies that waveguide systems need to be realized with smaller feature size. MEMS wafer processing technology inherently holds the key capability of enabling very precise and repeatable micromachining of micro scale electromechanical systems in mass production. In future transceiver systems it is of interest to achieve very small and precise waveguide structures using micro manufacturing technologies with inherent high precision and repeatability in high volume manufacturing thus enabling the possibility of making low cost mechanical waveguide structures that meet specifications for the intended RF frequency without need for additional tuning Furthermore, a cost efficient method of coupling the signal into the cavity filter is desirable as well as possibly integrating also the radio frequency integrated circuit (RFIC) with high precision relative to the waveguide structure.

The document "Design and Characterization of a W-Band Micromachined Cavity Filter Including a Novel Integrated Transition From CPW Feeding Lines" (Yun Lee et al) in IEEE Transactions on Microwave Theory and Techniques, vol. 55, no. 12, December 2007, pp. 2902-2910 discloses a coplanar waveguide (CPW) to rectangular waveguide (RWG) transition.

The documents "W-Band Bandpass Filter using Micromachined Air-Cavity Resonator With Current Probes" (S Song et al) in IEEE Microwave and Wireless Components Letters, vol. 20, no. 4, April 2010, pp. 205-207 **and** "All-Silicon Technology for High-Q Evanescent Mode Cavity Tuneable Resonators and Filters" (M S Arif et al) in Journal of Microelectromechanical Systems, vol. 23, no. 3, June 2014, pp. 727-739 disclose probes that protrude from a waveguide lid towards a conductor.

The document US 2004/129958 discloses a filter has suspended metal structures which are surrounded by a metal shield on all sides, except at the input and output ports. The signal can be coupled into and out of the filter either by coplanar waveguide ports, stripline ports, or through a waveguide connection.

The document "Micromachined filters in multilayer technology for on-board communication systems in Ka-band" (L Pellicia et al) in IEEE MTTS International Microwave Symposium Digest, June 2013, pp. 1-3 discloses a silicon based cavity filter that comprises slot-coupled input and output ports in the top substrate layer

### BRIEF DESCRIPTION OF THE DRAWINGS

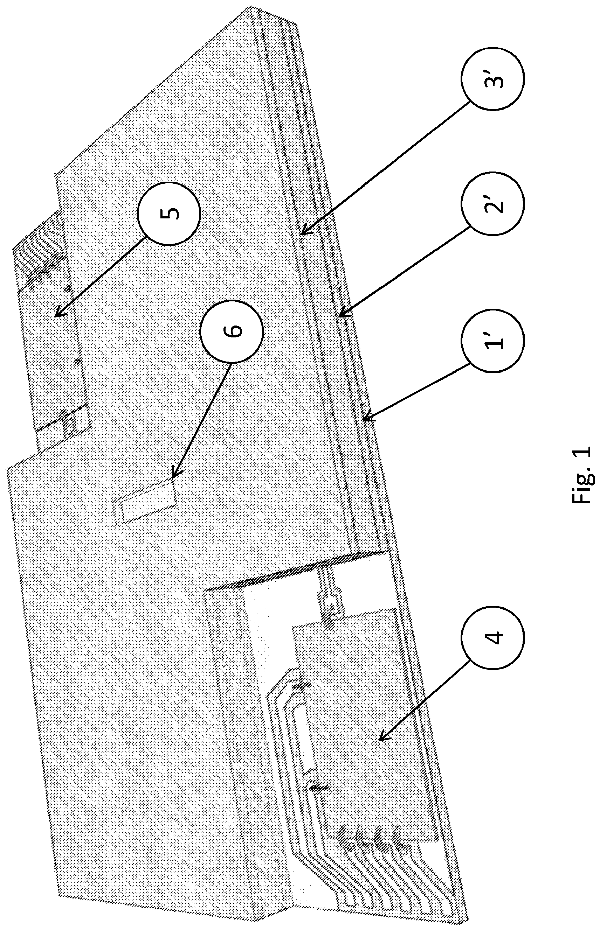

FIG. 1-6 shows the MEMS based waveguide system technology exemplified as a waveguide cavity filter with planar RF transmission line signal access into the cavity filter structure and on-chip integration of radio frequency integrated circuits

### DETAILED DESCRIPTION OF THE INVENTION

The present invention discloses the inventive concept of a waveguide cavity structure formed out of at least two structured and metallized wafer substrates bonded together and having a planar RF transmission line signal routing access to the waveguide cavity structure realized using the metallization layer deposited on the wafer substrate material of at least one of the wafers in the wafer stack.

Such cavity waveguide structure, having impedance adapted RF signal access, enables a plurality of applications, e.g. microwave waveguide cavity filters, antenna systems, straight waveguides and orthomode transducers OMT. The resulting highly integrated waveguide chip is suitable for deployment in high frequency transceiver (TRX) systems in general.

The invention can be used to make a single radio communication chip integrating for example the microwave cavity filter, antenna port, antenna and radio frequency integrated circuits (RFIC) into one single microsystem. In such realization, the microwave waveguide cavity filter on the transmitter side filters out the selected signal frequency and passes it on to the antenna. On the receiver side it filters out the desired RF signal and feeds it into the receiving chip.

With the migration to higher frequencies and shorter wavelength, the invention also holds a broader deployment area as a semiconductor manufacturing based mass production platform for highly integrated high frequency broadband communication solutions (waveguide interposers) based on the disclosed micro scale waveguide MEMS chip technology.

FIG. 1 shows a singulated (diced) MEMS chip. **1, 2** and **3** show the residual wafer bonding interfaces from the integration of multiple structured wafers assembled on top of each other in a wafer stack that constitutes the waveguide chip technology. The MEMS chip is suitably made of structured silicon or glass wafers bonded together, although other materials are possible. **4** and **5** represents optional RFIC's mounted directly on the MEMS chip. **6** represents an optional antenna port structured in the top wafer substrate.

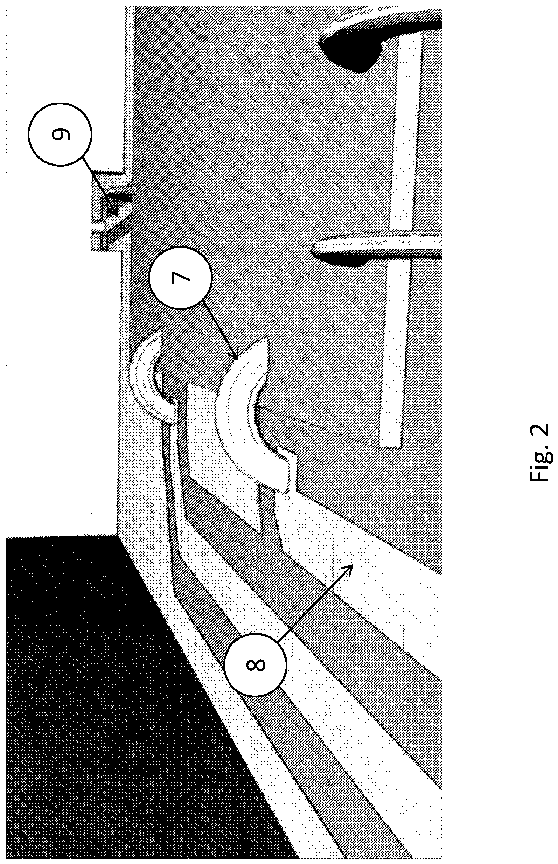

FIG 2. shows in more detail how an RFIC can be integrated by means of **7** wire bonding technology (or flip chip technology) to connect the RFIC to a pattern of metal traces **8** on the top surface of a wafer. The metal traces **8** defined on the surface of a wafer in the wafer stack has the function to constitute pads for wire bonding interconnects as well as routing electrical signals to a select position on the chip and finally also constituting the planar RF transmission line signal access into the cavity structure **9**. The wafer level patterned metal traces **8** constitutes both a separate signal routing and a planar RF transmission line. Another functional feature of the metal traces can be the provision of a wafer level integrated capacitor structures.

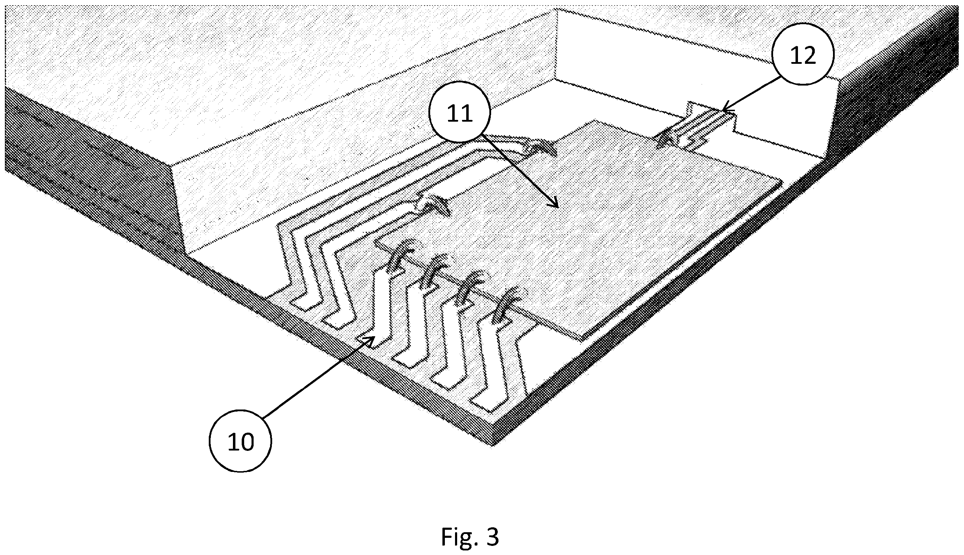

FIG 3. shows how electrical access can be realized from wire bond pads **10** at the edge of the MEMS waveguide chip, carrying multiple electrical connections to an on-chip mounted RFIC **11** eventually connecting to a planar RF transmission line carrying the signal through an opening port **12** in the waveguide, structured in the wafer material above the bottom wafer, and of varying height and width to accommodate required RF impedance matching.

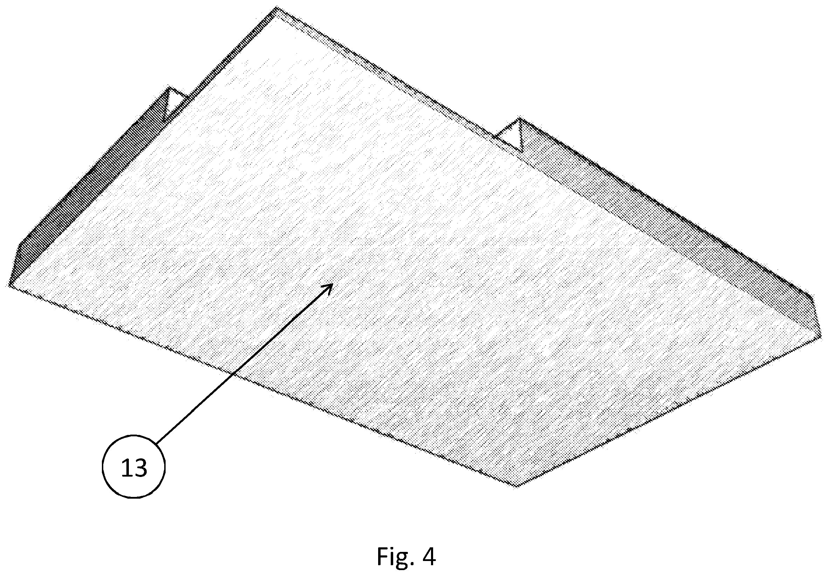

FIG 4. **13** shows the bottom of the MEMS chip that may have an optional metal coating to facilitate heat distribution and dissipation and also constitute an RF shield or ground plane for the planar RF transmission line structures (coplanar or microstrip)

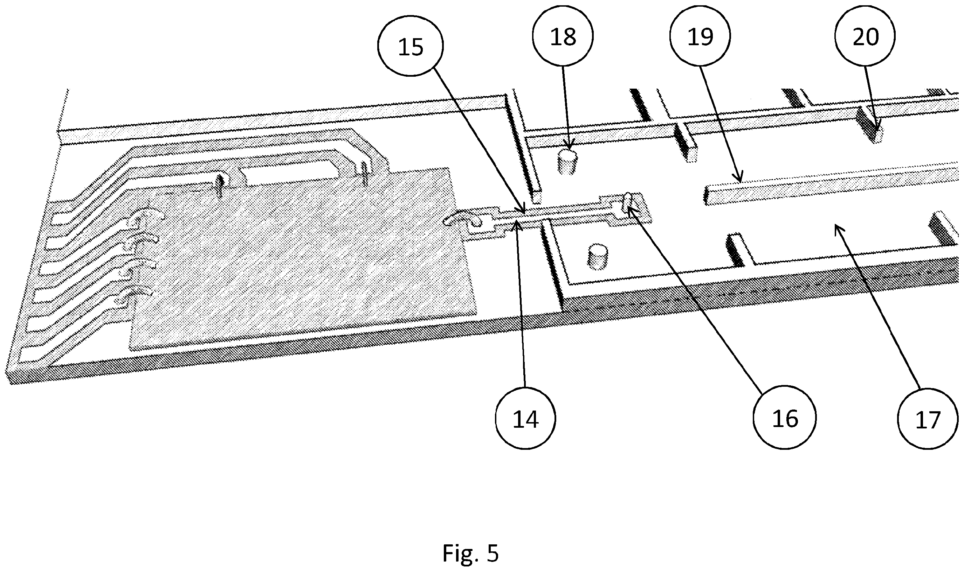

FIG 5. shows an embodiment of the planar RF transmission line signal access defined in the patterned metal on one of the wafers' top surface by means of separating the signal trace **14** from the ground plane of the system using an isolating gap **15** in the metal pattern. A metallized "probe" **16** is structured in the wafer material protruding from the ground plane of the system, allowing the resulting structure to act as an antenna inside the waveguide cavity, thereby allowing an efficient transition of the signal between the planar RF transmission line and the waveguide **17**. In the case of realizing the metal pattern on top of a conducting or semiconducting substrate, an isolation layer must be present in the shape of a residual buried oxide from an SOI wafer or be created on the surface underneath the patterned metal. In the same substrate planes that support the metal trace pattern, other protruding metallized or non-metallized protruding elements of the waveguide structure can be realized such as additional waveguide access ports and openings, tuning elements **18,** waveguide cavity "ridges" **19** as well as the side walls and "irises" **20** of the waveguide cavity structure.

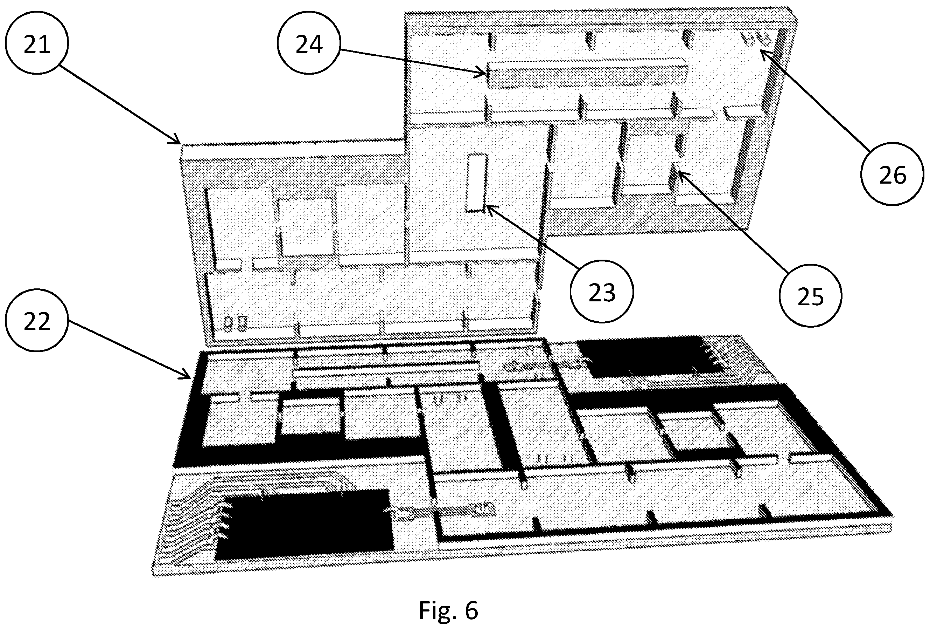

FIG 6. shows an exploded view of the MEMS waveguide chip looking from the bottom into the top of a structured wafer **21** where **21** constitutes a functional match to **22**. Most of the **21** wafer surface facing **22** is metallized to contain the RF signal inside the cavity circumference but may also have the metal layer patterned and may also contain additional features such as waveguide antenna port structures **23,** "ridges" **24,** "irises" **25** and "tuning elements" **26**. **21** and **22** aligned and snapped together in the same horizontal plane constitute the completed waveguide chip solution as in FIG 1.

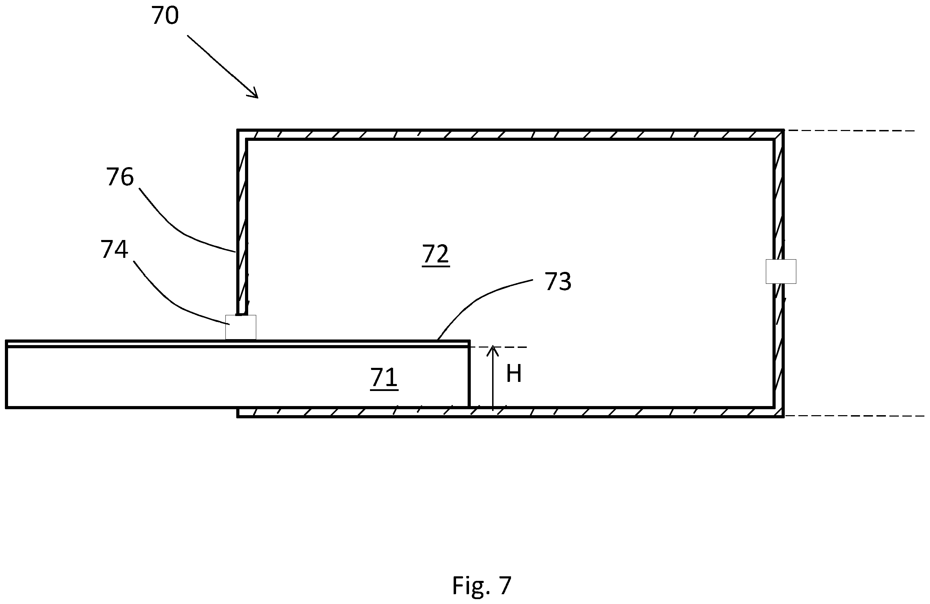

In Fig. 7 another embodiment of the invention is disclosed. The waveguide 70 is only schematically indicated.

Here there is no protruding "probe" extending from the ground plane of the system. Instead a spacer element is provided in form of a silicon ridge or rim 71 that has a finite height H over the ground plane of the system, i.e. the bottom of the waveguide cavity 72. This ridge or rim is metallized 73 and extends from outside of the cavity through the opening 74 in the side wall 76 of the cavity 72. The metallization that is provided at a distance above the ground plane and will have the same function as the probe 16 disclosed in Fig. 5.

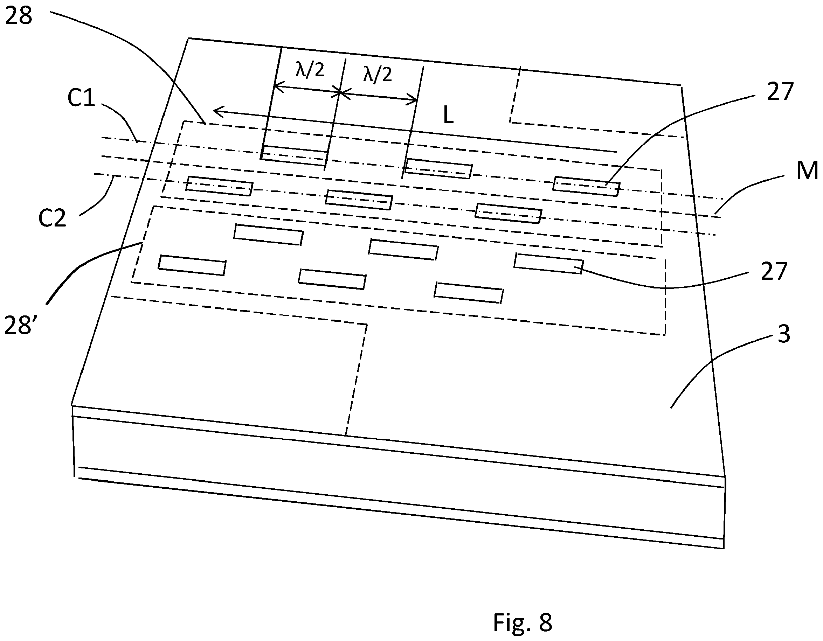

In a preferred embodiment the waveguide system comprises at least one, preferably a plurality of slot antennas, provided in the top wafer structure 3. This is shown schematically in Fig. 8.

Thus, in the top wafer 3 a plurality of narrow slots 27 are provided (not to scale in the figure). The slots open into a cavity or several cavities schematically indicated with a broken line contour 28.

The slots 27 are typically and preferably half a wave length (λ/2) long and a tenth of a wavelength wide, and are preferably laid out in a pattern as shown, where every second slot is on one side of the middle M of the extension of the wave guide and every second on the other said i.e. in a "staggered" configuration, although this is not strictly necessary. The slots are suitably spaced apart about half a wave length in longitudinal direction (shown with arrow L). Preferably the slots are located essentially at equal distances from an imaginary center line indicated with M in Fig. 7, and the outer contour of the waveguide cavity 28, i.e. they are suitably arranged on a line indicated with C1 and C2, respectively, in Fig. 7.

In embodiments there can be provided several arrays of slots 27 in adjacent cavities 28, 28' as shown in Fig. 8. The number of cavities is not limited by other than practical considerations, and there should preferably be at least one slot in each cavity, although it would be possible to have some cavities without slots.

The length L of the slots could in principle be approximately (+ 10% to ± 20%) given as L = (λ/2 + nλ). wherein n = 0, 1, 2, ,... , and λ is the wave length of the working frequency of the device, but the performance would not be as good for n > 0. The width of the slots is suitably essentially λ /3 to λ /15, preferably about λ /10.

In one method of making the waveguide system, at least two starting substrates in the form of a semiconductor wafer, preferably but not limited to an SOI wafer (Silicon On Insulator), high resistivity silicon wafer or glass wafer is provided, having two sides. At least one wafer is processed to achieve a plurality of high aspect ratio vertical features on at least one side of the wafer by means of a sequence of standard substrate lithography patterning and subsequent substrate etching steps such as Deep Reactive Ion Etching (DRIE), where some features may constitute hole features extending through the entire thickness of the wafer.

At least two wafers in the wafer stack have metal deposited by means of a wafer level process such as sputtering, electroplating, evaporation, spray painting or screen printing on at least one side of the wafer and the metallized surfaces of at least two of the wafers in the stack are facing each other where at least one of the metallized surfaces has been patterned to constitute a planar RF transmission line as in FIG. 5 **14.** In the case of realizing the metal pattern on top of a conducting or semiconducting substrate surface, an isolation layer must be present in the shape of a residual buried oxide from an SOI wafer or be created on the top surface underneath the patterned metal.

The processed wafer substrates are joined together in a sequence of MEMS wafer bonding steps that may contain optional wafer etching, thinning and backgrinding steps and also metallization steps to form the wafer bonding interfaces for MEMS wafer bonding. An etching or dicing step separates the individual MEMS chips from the bonded wafer structure and RF IC's can optionally be mounted on the MEMS chip by a suitable die attach technology (like wire bonding, gluing or flip chip bonding) directly on the patterned metal layer as represented in FIG 1.

## Claims

1. A waveguide system in the form of a MEMS chip, comprising at least two silicon wafer substrates bonded together and forming a structure comprising: a waveguide structure comprising a waveguide (17) having at least one opening port (12), said waveguide structure being made substantially from a silicon substrate where at least one metal pattern (8) and a ground plane of the system are provided on said silicon substrate, wherein the metal pattern (8) is configured to constitute a signal routing and/or provide a planar RF transmission line (14) that is separated from the ground plane of the system by an isolating gap (15) in the metal pattern (8), where the RF transmission line (14) is adapted to carry the signal through the opening port (12) into a cavity (9) of the waveguide (17), which cavity (9) faces away from the RF transmission line (14), the waveguide system further comprising a metallized electric probe (16) structured in the wafer material, protruding from the ground plane of the system, and coupled to the signal routing and/or the transmission line (14), such that the resulting structure is adapted to act as an antenna inside the waveguide (17), thereby enabling an efficient transition of the signal between the planar RF transmission line (14) and the waveguide (17), where the ground plane of the system **is** in a substrate plane that is configured to support the metal pattern (8).

2. A waveguide system, as claimed in claim 1, further comprising at least one semiconductor chip (RFIC) assembled onto and electrically connected to the metal pattern (8) configured to constitute signal routing and/or provide a planar RF transmission line (14).

3. A waveguide system, as claimed in claim 1, further comprising at least one antenna port (6), structured in one of the at least two silicon wafer substrates forming a top wafer substrate, opening into the cavity of the waveguide.

4. A waveguide system, as claimed in claim 1, further comprising at least one passive component selected from a capacitor, resistor, varactor, pin diode or field effect transistor, assembled and electrically connected to the metal pattern configured to constitute a signal routing and/or provide a planar RF transmission line (14).

5. A waveguide system, as claimed in claim 1 further comprising at least one wafer level integrated mechanical tuning element (26) inside the waveguide.

6. A waveguide system, as claimed in claim 1, further comprising at least one wafer level integrated ridge (24) inside the waveguide.

7. A waveguide system, as claimed in claim 1, with at least one wafer level integrated iris (25) inside the waveguide.

8. A waveguide system, as claimed in claim 1, further comprising at least one wafer level integrated tuning element (26) inside the waveguide.

9. A waveguide system, as claimed in claim 1, further comprising an isolated contact pad and at least one through substrate via, TSV, connecting the metal pattern configured to constitute signal routing and/or provide a planar RF transmission line to the isolated contact pad at the top or bottom surface of the waveguide system.

10. A waveguide system, as claimed in claim 1, further comprising at least one wafer level integrated electrostatically actuatable mechanical feature connected to the metal pattern configured to constitute signal routing and/or provide a planar RF transmission line.

11. A waveguide system, as claimed in claim 1, further comprising at least one wafer level integrated piezoelectrically actuatable mechanical feature connected to the metal pattern configured to constitute signal routing and/or a planar RF transmission line,

12. A waveguide system, as claimed in claim 1, further comprising at least one wafer level integrated passive electric function realized in the metal pattern configured to constitute signal routing and/or a planar RF transmission line.

13. A waveguide system, as claimed in claim 1, where the cavity is filled with a dielectric material other than air and configured to modify the RF properties of the cavity.

## Patentansprüche

1. Ein Wellenleitersystem in Form eines MEMS-Chips, umfassend mindestens zwei Silizium-Wafer-Substrate miteinander verklebt und mit einer Struktur, umfassend: eine Wellenleiterstruktur mit einem Wellenleiter (17) mit mindestens eine Öffnung (12) aufweist, wobei die Wellenleiterstruktur im wesentlichen aus einem Siliziumsubstrat hergestellt sein, auf dem mindestens ein Metallmuster (8) und eine Grundebene des Systems auf dem Siliziumsubstrat vorgesehen sind, wobei das Metallmuster (8) ist konfiguriert, um eine Signalführung zu bilden und / oder eine planare HF-Übertragungsleitung (14) bereitzustellen, die von der Grundebene des Systems durch einen Isolierspalt (15) in dem Metallmuster (8) getrennt ist, wo die HF Die Übertragungsleitung (14) ist dazu ausgelegt, das Signal durch die Öffnungsöffnung (12) in einen Hohlraum (9) des Wellenleiters (17) zu leiten, dessen Hohlraum (9) von der HF-Übertragungsleitung (14) weg zeigt Wellenleitersystem, ferner umfassend eine metallisierte elektrische Sonde (16), die in dem Wafermaterial strukturiert ist, aus der Masseebene des Systems herausragt und mit der Signalleitung und / oder der Übertragungsleitung (14) gekoppelt ist, so dass die resultierende Struktur an angepasst ist wirken als Antenne innerhalb des Wellenleiters (17) und ermöglichen dadurch einen effizienten Übergang des Signals zwischen der planaren HF-Übertragungsleitung (14) und dem Wellenleiter (17), wobei sich die Masseebene des Systems in einer konfigurierten Substratebene befindet um das Metallmuster (8) zu stützen.

2. Ein Wellenleitersystem, wie in Anspruch 1 beansprucht, ferner aufweisend mindestens eine Halbleiterchips (RFIC) montiert auf und elektrisch mit dem Metall verbunden Muster (8) so konfiguriert bilden Signalführung und / oder liefern eine planare HF - Übertragungsleitung (14).

3. Ein Wellenleitersystem, wie in Anspruch 1, ferner umfassend mindestens einen Antennenanschluss (6), strukturiert in einem der mindestens zwei Wafer-Substraten, die ein oberes Wafer-Substrat bilden und sich in den Hohlraum des Wellenleiters öffnen.

4. Ein Wellenleitersystem, wie in Anspruch 1 beansprucht, ferner aufweisend zumindest eine passive Komponente, ausgewählt aus einem Kondensator, Widerstand, Varaktor, pin - Diode oder Feldeffekttransistor, zusammengebaut und elektrisch mit dem Metallmuster konfiguriert ist, um ein zu bilden Signalführung und / oder eine planare HF-Übertragungsleitung (14) bereitstellen.

5. Ein Wellenleitersystem, wie in Anspruch 1 beansprucht, ferner umfassend mindestens einen Wafer - Ebene integrierte mechanische Abstimmelement (26) innerhalb des Wellenleiters.

6. Ein Wellenleitersystem, wie in Anspruch 1 beansprucht, dadurch weiter umfassend mindestens eine Wafer - Ebene integrierte Rippe (24) innerhalb des Wellenleiters.

7. Ein Wellenleitersystem, wie in Anspruch 1 beansprucht, mit mindestens ein Wafer - Ebene integrierte Iris (25) im Inneren des Wellenleiters.

8. Ein Wellenleitersystem, wie in Anspruch 1 beansprucht, weiterhin umfassend mindestens eine Wafer - Ebene integrierten Abstimmelement (26) innerhalb des Wellenleiters.

9. Ein Wellenleitersystem, wie in Anspruch 1 beansprucht, das weiterhin ein isoliertes Kontaktpad und mindestens ein Silizium durch Kontakt, TSV, liefert, das das Metallmuster zu einer Signalleitung und/oder einer planaren HF-Übertragungsleitung mit dem isolierten Kontaktpad an der Ober- oder Unterseite des Wellenleitersystems verbindet.

10. Ein Wellenleitersystem, wie in Anspruch 1 beansprucht, ferner aufweisend mindestens eine Wafer - Ebene integrierten elektrostatischen betätigbare mechanisches Merkmal der mit dem Metallmuster konfiguriert Signal zu bilden, das Routing und / oder eine liefern Linie planar RF - Übertragung.

11. Ein Wellenleitersystem, wie in Anspruch 1 beansprucht, ferner aufweisend mindestens eine Wafer - Ebene integrierten piezoelektrisch betätig bares mechanisches Merkmal an das Metall angeschlossenes Muster konfiguriert Signal bilden Routing und / oder eine Übertragungsleitung planar RF.

12. Ein Wellenleitersystem, wie in Anspruch 1 beansprucht, ferner aufweisend mindestens eine Wafer - Ebene integrierten passive elektrische Funktion realisiert in dem Metallmuster konfiguriert Signal bilden Routing und / oder eine Übertragungsleitung planar RF.

13. Ein Wellenleitersystem, wie in Anspruch 1 beansprucht, wobei der Hohlraum mit einem dielektrischen Material gefüllt ist, anders als Luft ist und konfiguriert ist, die RF zu modifizieren Eigenschaften des Hohlraums.

## Revendications

1. Système de guide d'ondes sous la forme d'une puce MEMS, comprenant au moins deux substrats de plaquette de silicium liés entre eux et formant une structure comprenant: une structure de guide d'ondes comprenant un guide d'ondes (17) ayant au moins un orifice d'ouverture (12), ladite structure de guide d'ondes étant constitué essentiellement d'un substrat de silicium où au moins un motif métallique (8) et un plan de masse du système sont prévus sur ledit substrat de silicium, dans lequel le motif métallique (8) est configuré pour constituer un acheminement de signal et / ou fournir une ligne de transmission RF plane (14) qui est séparée du plan de masse du système par un espace isolant (15) dans le motif métallique (8), où le RF la ligne de transmission (14) est adaptée pour transporter le signal à travers le port d'ouverture (12) dans une cavité (9) du guide d'ondes (17), laquelle cavité (9) est opposée à la ligne de transmission RF (14), le système de guide d'ondes comprenant en outre une sonde électrique métallisée (16) structurée dans le matériau de la tranche, faisant saillie du plan de masse du système, et couplée à l'acheminement du signal et / ou à la ligne de transmission (14), de sorte que la structure résultante est adaptée pour agir comme une antenne à l'intérieur du guide d'ondes (17), permettant ainsi une transition efficace du signal entre la ligne de transmission RF plane (14) et le guide d'ondes (17), où le plan de masse du système est dans un plan de substrat qui est configuré pour supporter le motif métallique (8).

2. Système de guide d'ondes selon la revendication 1, comprenant en outre au moins un puce à semi-conducteur (RFIC) assemblée et connectée électriquement au motif métallique (8) configuré pour constituer un routage de signal et / ou fournir une ligne de transmission RF plane (14).

3. Système de guide d'ondes selon la revendication 1, comprenant en outre au moins un port d'antenne (6), structuré dans l'un des au moins deux substrats de plaquette de silicium formant un substrat de plaquette supérieur, débouchant dans la cavité du guide d'ondes.

4. Système de guide d'ondes selon la revendication 1, comprenant en outre au moins un composant passif choisi parmi un condensateur, une résistance, un varacteur, une diode pin ou un transistor à effet de champ, assemblé et connecté électriquement au motif métallique configuré pour constituer un routage de signal et / ou fournir une ligne de transmission RF plane (14).

5. Système de guide d'ondes selon la revendication 1, comprenant en outre au moins un élément d'accord mécanique intégré au niveau de la tranche (26) à l'intérieur du guide d'ondes.

6. Système de guide d'ondes selon la revendication 1, comprenant en outre au moins une arête intégrée au niveau de la tranche (24) à l'intérieur du guide d'ondes.

7. Système de guide d'ondes selon la revendication 1, avec au moins un niveau de tranche iris intégré (25) à l' intérieur du guide d'ondes.

8. Système de guide d'ondes selon la revendication 1, comprenant en outre au moins un élément d'accord intégré au niveau de la tranche (26) à l'intérieur du guide d'ondes.

9. Système de guide d'ondes selon la revendication 1, comprenant en outre un plot de contact isolé et au moins un substrat traversant via, TSV, reliant le motif m étal. configuré pour constituer un routage de signal et / ou fournir une ligne de transmission RF plane à le plot de contact isolé sur la surface supérieure ou inférieure du système de guide d'ondes.

10. Système de guide d'ondes selon la revendication 1, comprenant en outre au moins une caractéristique mécanique actionnable électrostatiquement intégrée au niveau de la plaquette connectée au motif métallique configuré pour constituer un routage de signal et / ou fournir une ligne de transmission RF plane.

11. Système de guide d'ondes selon la revendication 1, comprenant en outre au moins une caractéristique mécanique actionnable piézoélectriquement intégrée au niveau de la plaquette connectée au motif métallique configuré pour constituer un routage de signal et / ou une ligne de transmission RF plane.

12. Système de guide d'ondes selon la revendication 1, comprenant en outre au moins une fonction électrique passive intégrée au niveau de la tranche réalisée dans le motif métallique configuré pour constituer un routage de signal et / ou une ligne de transmission RF plane.

13. Système de guide d'ondes selon la revendication 1, dans lequel la cavité est remplie d'un matériau diélectrique autre que l' air et configuré pour modifier les propriétés RF de la cavité.
